# EUROPÄISCHE PATENTANMELDUNG

(11) **EP 3 211 111 A2**
(43) Veröffentlichungstag der Anmeldung: **30.08.2017**
(21) Anmeldenummer: 17154295.4
(22) Anmeldetag: 02.02.2017
(51) Int. Cl.: C22F 1/10, B22F 3/15, C23C 4/00, C23C 14/00, C23C 16/00, C22C 19/05

(54) **WÄRMEBEHANDLUNGSVERFAHREN FÜR BAUTEILE AUS NICKELBASIS-SUPERLEGIERUNGEN**

(30) Priorität: 24.02.2016 DE 102016202837
(71) Anmelder: MTU Aero Engines AG, 80995 München (DE)
(72) Erfinder: Göhler, Thomas, 85221 Dachau (DE); Sowa, Roman, 37-203 Gniewczyna (PL); Rettig, Ralf, 91058 Erlangen (DE); Ritter, Nils, 91058 Erlangen (DE); Singer, Robert F., 91054 Erlangen (DE)

(57) **Zusammenfassung**

Die vorliegende Erfindung betrifft ein Verfahren zur Herstellung eines Bauteils, aus einer Nickelbasis - Superlegierung, insbesondere eines Bauteils einer Strömungsmaschine, bei welchem ein Halbzeug des Bauteils einer Lösungsglühbehandlung und einer Ausscheidungsglühbehandlung unterzogen wird, wobei die Lösungsglühbehandlung in einem Temperaturbereich von 1300°C bis 1350°C und die Ausscheidungsglühbehandlung im Temperaturbereich von 900°C bis 1150°C durchgeführt wird, wobei die Lösungsglühbehandlung und/oder die Ausscheidungsglühbehandlung zusammen mit einer weiteren Bearbeitung des Halbzeugs durchgeführt werden. Die Erfindung betrifft weiterhin ein Verfahren zur Aufarbeitung eines Bauteils aus einer Nickelbasis - Superlegierung, insbesondere eines Bauteils einer Strömungsmaschine, nach mehreren hundert Stunden Einsatz bei einer Einsatztemperatur von mehr als 500°C, wobei eine Wiederaufarbeitungswärmebehandlung in einem Temperaturbereich von 1100°C bis 1280°C durchgeführt wird.

## Beschreibung

### HINTERGRUND DER ERFINDUNG

### GEBIET DER ERFINDUNG

Die Erfindung betrifft Wärmebehandlungsverfahren von Nickelbasis - Superlegierungen für die Herstellung und Aufarbeitung von Bauteilen, vorzugsweise Bauteilen von Strömungsmaschinen, wie Flugtriebwerken oder stationären Gasturbinen.

Unter Nickelbasislegierung ist ein Werkstoff zu verstehen, der im Hauptbestandteil Nickel aufweist. Eine besondere Ausgestaltung von Nickelbasislegierungen stellen Nickelbasis - Superlegierungen dar, unter denen Legierungen zu verstehen sind, die durch ihre besondere Zusammensetzung und Gefügeausbildung bei hohen Temperaturen bis nahe zu ihrem Schmelzpunkt einsetzbar sind.

### STAND DER TECHNIK

Nickelbasis - Superlegierungen werden bei Hochtemperaturanwendungen, z. B. beim Bau von stationären Gasturbinen oder Flugtriebwerken, aufgrund ihrer Hochtemperaturfestigkeit eingesetzt. Unter Hochtemperaturanwendung wird hierbei eine Anwendung verstanden, bei der die Einsatztemperatur eines aus der Legierung hergestellten Bauteils in einem Temperaturbereich oberhalb der halben Schmelztemperatur der Legierung liegt.

Die Nickelbasis - Superlegierungen verdanken ihre guten Hochtemperatureigenschaften und insbesondere ihre hervorragende Hochtemperaturfestigkeit einer speziellen Gefügeausbildung, die durch eine y - Matrix und darin eingelagerte y' - Ausscheidungen gekennzeichnet ist. Die kubisch flächenzentrierte y - Phase der Matrix besteht aus dem Hauptbestandteil Nickel sowie Elementen wie Kobalt, Chrom, Molybdän, Rhenium und Wolfram, die zu Nickelbasis - Superlegierungen hinzulegiert werden. Durch derartige Legierungsbestandteile, wie Wolfram, Rhenium und Molybdän, wird eine Mischkristallverfestigung der y - Matrix erzielt, die der Legierung zusätzlich zur Ausscheidungshärtung mit den y' - Ausscheidungen Festigkeit verleiht.

Die Legierungsbestandteile Rhenium, Wolfram und Molybdän erzeugen neben der Mischkristallverfestigung der y - Matrix zusätzlich eine Stabilisierung der y' - Ausscheidungen und wirken deren Vergröberung, die zu einem Abfall der Kriechfestigkeit führen würde, entgegen.

Allerdings besteht bei der Zulegierung von Refraktärmetallen, wie Rhenium, Wolfram und Molybdän das Problem, dass sich sogenannte TCP - Phasen (TCP topological closed packed (topologisch dicht gepackt)) bilden, die spröde sind und zur Rissbildung führen können.

Die γ' - Ausscheidungsphasen besitzen üblicherweise ebenfalls eine kubisch flächenzentrierte Struktur mit der Zusammensetzung Ni₃(Al,Ti,Ta,Nb).

Darüber hinaus kann die Festigkeit von Nickelbasis - Superlegierungen durch die Bildung von Karbiden erhöht werden, die die Korngrenzen stabilisieren und somit einen Beitrag zur Kriechfestigkeit leisten.

Für das Eigenschaftsprofil von Nickelbasis - Superlegierungen bei Hochtemperaturanwendungen ist deshalb die Gefügeausbildung und - stabilität von entscheidender Bedeutung.

Aus dem Stand der Technik ist es bereits bekannt, bei entsprechenden Nickelbasis - Superlegierungen nach dem Gießen eines Halbzeugs bzw. bei einkristallin ausgebildeten Bauteilen nach der einkristallinen Herstellung des Halbzeugs die entsprechenden Halbzeuge einer Wärmebehandlung zu unterziehen, die üblicherweise eine Lösungsglühbehandlung und eine Ausscheidungsglühbehandlung zur Ausscheidung der γ' - Ausscheidungsphasen umfasst.

Für eine Nickelbasis - Superlegierung der neuesten Generation, z.B. der Legierung TMS - 238 (Legierungsbezeichnung des National Institute for Materials Science, Japan), werden beispielsweise eine Lösungsglühbehandlung bei mehreren Haltetemperaturen im Bereich von 1230°C bis 1340°C sowie eine zweistufige Ausscheidungsglühbehandlung im Temperaturbereich von 1000°C bis 1150°C und bei 870°C vorgeschlagen (siehe US 8 771 440 B2 und CA 02 508 688 A1). Bei der Lösungsglühbehandlung wird entsprechend eine Temperierung bei einer Haltetemperatur von 1300° Celsius für eine Stunde sowie bei einer Haltetemperatur bei 1340° Celsius für fünf Stunden oder mehr vorgeschlagen, während die Ausscheidungsglühbehandlung in einer ersten Stufe bei einer Temperatur von 1000°C bis 1150°C für vier Stunden durchgeführt wird, während die zweite Stufe der Ausscheidungsglühbehandlung bei einer Haltedauer von 20 Stunden bei 870°C stattfindet.

Dies verdeutlicht, dass der Aufwand für die Herstellung eines entsprechenden Bauteils aus einer Nickelbasis - Superlegierung sehr hoch ist und dass es entsprechend von Interesse ist, diesen Aufwand zu reduzieren. Darüber hinaus ist sicherzustellen, dass derartig aufwändig hergestellte Bauteile eine möglichst lange Lebensdauer aufweisen, was durch die Bildung der sogenannten TCP - Phasen während des Einsatzes bei hohen Temperaturen unter Umständen zunichte gemacht werden kann.

### OFFENBARUNG DER ERFINDUNG

### AUFGABE DER ERFINDUNG

Es ist deshalb Aufgabe der vorliegenden Erfindung ein Verfahren zur Herstellung eines Bauteils aus einer Nickelbasis - Superlegierung anzugeben, bei dem der Aufwand für die Herstellung des Bauteils möglichst gering gehalten werden kann, aber gleichzeitig die gewünschten Eigenschaften des Bauteils eingestellt werden können. Darüber hinaus besteht die Aufgabe der Erfindung darin, bei einem entsprechenden Bauteil eine lange Lebensdauer des Bauteils zu ermöglichen.

### TECHNISCHE LÖSUNG

Diese Aufgabe wird gelöst durch ein Verfahren zur Herstellung eines Bauteils mit den Merkmalen des Anspruchs 1 sowie ein Verfahren zur Aufbereitung eines Bauteils aus einer Nickelbasis - Superlegierung mit den Merkmalen des Anspruchs 10. Vorteilhafte Ausgestaltungen sind Gegenstand der abhängigen Ansprüche.

Die Erfindung schlägt zur Lösung der oben genannten Aufgabenstellung nach einem ersten Aspekt der Erfindung vor, die erforderliche Wärmebehandlung mit Lösungsglühbehandlung und/oder Ausscheidungsglühbehandlung jeweils zusammen mit weiteren Bearbeitungsschritten zur Bearbeitung eines entsprechenden Halbzeugs aus einer Nickelbasis - Superlegierung durchzuführen. Damit können Bearbeitungszeiten und Aufwand bei der Herstellung entsprechender Bauteile deutlich reduziert werden.

Beispielsweise kann es bei gegossenen Halbzeugen zur Beseitigung von Poren und zur weiteren Verbesserung der mechanischen Eigenschaften vorteilhaft sein, das Halbzeug einer Bearbeitung durch heißisostatisches Pressen (HIP) zu unterziehen. Gemäß der Erfindung kann dies zumindest teilweise gleichzeitig mit der Lösungsglühbehandlung durchgeführt werden.

Darüber hinaus werden entsprechende Bauteile für Hochtemperaturanwendungen, wie beispielsweise in Flugtriebwerken oder stationären Gasturbinen, mit einer Schutzbeschichtung, beispielsweise einer Oxidationsschutzschicht, versehen, sodass gemäß der Erfindung eine entsprechende Abscheidung einer Schicht gleichzeitig mit einer Ausscheidungsglühbehandlung stattfinden kann. Durch das Kombinieren von unterschiedlichen Bearbeitungsschritten kann Zeit und Aufwand bei der Herstellung entsprechender Bauteile eingespart werden.

Zu diesem Zweck kann auch auf eine zweite Stufe einer Ausscheidungsglühbehandlung, wie sie im Stand der Technik vorgesehen ist, verzichtet werden. Entsprechend kann also bei der Herstellung eines entsprechenden Bauteils aus einer Nickelbasis - Superlegierung nach der Herstellung des Halbzeugs durch Gießen, gerichtetes Erstarren oder Einkristallziehen das Halbzeug einer Lösungsglühbehandlung unterzogen werden, die mit verschiedenen Haltetemperaturen durchgeführt werden kann. Nach dem Abschrecken des Bauteils mit einer schnellen Abkühlung auf Raumtemperatur oder nahezu Raumtemperatur kann sich dann eine einstufige Ausscheidungsglühbehandlung anschließen, wobei einstufig bedeutet, dass lediglich eine Haltetemperatur über einen längeren Zeitraum, beispielsweise mehr als fünf oder zehn Minuten, eingestellt wird. Es hat sich nämlich gezeigt, dass die im Stand der Technik beschriebene zweite Stufe der Ausscheidungsglühbehandlung bei einer niedrigeren Temperatur als bei der ersten Stufe, insbesondere einer Temperatur bei ca. 870°C, keinen wesentlichen Einfluss mehr auf die Ausbildung der γ' - Ausscheidungsphasen und insbesondere auf deren Durchmesser aufweist, sodass dieser Bearbeitungsschritt eingespart werden kann.

Stattdessen kann eine einstufige Ausscheidungsglühbehandlung im Temperaturbereich von 900°C bis 1150°C, insbesondere 1000°C bis 1100°C für eine Zeitdauer von fünf oder mehr Stunden, insbesondere zehn oder mehr Stunden, vorzugsweise zehn bis 25 Stunden durchgeführt werden, wobei durch die Kombination mit einem Beschichtungsprozess der Gesamtaufwand insgesamt niedrig gehalten werden kann.

Die Beschichtung, die während der Ausscheidungsglühbehandlung abgeschieden werden kann, kann eine oder mehrere Al - haltige Schichten, insbesondere AlCr - und / oder PtAl - Schichten bzw. reine Al - Schichten aufweisen.

Als Beschichtungsverfahren können verschiedene Verfahren eingesetzt werden, bei denen die entsprechenden Temperaturen für die Ausscheidungsglühbehandlung zumindest in einem Teilschritt auf das Halbzeug aufgebracht werden können, wie beispielsweise chemische und/oder physikalische Dampfphasenabscheidungen (CVD chemical vapor deposition oder PVD physical vapor deposition), oder Spritzverfahren, wie beispielsweise Heißgasspritzen, Hochgeschwindigkeitsflammspritzen oder Niederdruckplasmaspritzen, oder thermochemische Diffusionsbehandlungen, wie Chromieren oder Alitieren. Die Beschichtung kann auch durch Verdampfen (z.B. Laserstrahlverdampfen oder Elektronenstrahlverdampfen) oder Kathodenzerstäubung (Sputtern) oder elektrochemisches Abscheiden von Bestandteilen der Schicht, wie beispielsweise Platin, zusätzliches Abscheiden von anderen Bestandteilen wie Aluminium durch gleiche oder ähnliche Verfahren, und Fertigstellen der Schicht durch Ermöglichung von Diffusionsvorgängen während einer Glühbehandlung, die gleichzeitig die Ausscheidungsglühbehandlung ist, erzeugt werden.

Die Lösungsglühbehandlung kann, wie bereits vorher erwähnt, bei mehreren Haltetemperaturen insbesondere im Temperaturbereich von 1300° Celsius bis 1375° Celsius durchgeführt werden, wobei die letzte Haltetemperatur im Temperaturbereich von 1310° Celsius bis 1375° Celsius, insbesondere von 1340° Celsius bis 1350° Celsius liegen kann und für eine Dauer von bis zu 15 Stunden, insbesondere bis zu zehn Stunden vorzugsweise bis zu fünf Stunden gehalten werden kann. Die Lösungsglühbehandlung kann mit einer Abkühlung mit einer Kühlrate von 200 K/min oder mehr, vorzugsweise 400 K/min oder mehr beendet werden.

Nach einem weiteren Aspekt der vorliegenden Erfindung, für den selbstständig und in Kombination mit anderen Aspekten der Erfindung Schutz begehrt wird, wird ein Verfahren zur Aufarbeitung eines Bauteils aus einer Nickelbasis - Superlegierung vorgeschlagen, bei welchem bei einem Bauteil nach Einsatz über mehrere 100 Stunden, wie beispielsweise 200 Stunden oder mehr, insbesondere 1000 Stunden oder mehr, bei einer Einsatztemperatur von mehr als 500°C, insbesondere mehr als 750°C bzw. im Bereich von 900°C bis 1100°C, eine Wiederaufarbeitungswärmebehandlung in einem Temperaturbereich von 1080°C bis 1280°C durchgeführt wird, um möglicherweise entstandene TCP - Phasen wieder aufzulösen.

Die Wiederaufarbeitungswärmebehandlung kann insbesondere bei einer Temperatur von 1125°C bis 1275°C und vorzugsweise im Temperaturbereich von 1150°C bis 1200°C durchgeführt werden. Die Zeitdauer der Wiederaufarbeitungswärmebehandlung kann mehr als zehn Stunden, insbesondere mehr als 20 Stunden und vorzugsweise mehr als 25 Stunden betragen, um eine sichere Auflösung sämtlicher TCP - Phasen sicherzustellen. Durch die Auflösung der TCP - Phasen wird die mechanische Festigkeit des Bauteils nach einem längeren Einsatz bei höheren Temperaturen wieder verbessert und entsprechende Bauteile können für einen längeren Zeitraum eingesetzt werden können.

Vor der Wiederaufarbeitungswärmebehandlung kann ein Spannungsarmglühen des zu behandelnden Bauteils bei einer Temperatur von 850°C bis 1100°C für eine Zeitdauer von 1 bis 5 Stunden, insbesondere 2 bis 4 Stunden erfolgen, um im Bauteil aufgebaute Eigenspannungen abzubauen.

An die Wiederaufarbeitungswärmebehandlung kann sich eine zusätzliche Ausscheidungsglühbehandlung in Kombination mit oder ohne einer Beschichtung anschließen, wie dies oben im Zusammenhang mit dem Herstellungsverfahren beschrieben worden ist.

Die vorher beschriebenen Verfahren können insbesondere bei Nickelbasis - Superlegierungen der neuesten Generation, wie beispielsweise der Legierung TMS - 238 oder Legierungen eingesetzt werden, die folgende Zusammensetzung in Gewichtsprozent aufweisen:
3,7 bis 7,0 %, vorzugsweise 5,0 bis 7,0 %, insbesondere 5,5 bis 6,0 % Al
6 bis 20 %, vorzugsweise 6 bis 8 % oder 10 bis 15,0 %, insbesondere 10,0 bis 12,0 % Co
2,1 bis 7,2 %, vorzugsweise 4,0 bis 6,0 %, insbesondere 4,5 bis 5,5 % Cr
1,0 bis 3,0 %, vorzugsweise 1,1 bis 2,5 %, insbesondere 1,1 bis 2,0 % Mo
5,0 bis 9,2 %, vorzugsweise 5,5 bis 7,0 %, insbesondere 5,7 bis 6,5 % Re
3,0 bis 8,5 %, vorzugsweise 3,1 bis 5,5 %, insbesondere 3,3 bis 5,0 % Ru
4,1 bis 11,9 %, vorzugsweise 5,0 bis 9,0 %, insbesondere 5,5 bis 8,0 % Ta
0 bis 3,3 %, vorzugsweise 0 bis 2,0 %, insbesondere 0 bis 1,7 % Ti
2,1 bis 4,9 %, vorzugsweise 3,0 bis 4,5 %, insbesondere 3,5 bis 4,5 % W
0 bis 0,05 % C
0 bis 0,1 % Si
0 bis 0,05 % Mn
0 bis 0,015 % P
0 bis 0,001 % S
0 bis 0,003 % B
0 bis 0,05 % Cu
0 bis 0,15 % Fe
0 bis 0,5 %, vorzugsweise 0 bis 0,15 % Hf
0 bis 0,015 % Zr
0 bis 0,001 % Y
und Rest Nickel sowie unvermeidbare Verunreinigungen.

### AUSFÜHRUNGSBEISPIEL

Weitere Vorteile, Kennzeichen und Merkmale der vorliegenden Erfindung werden bei der nachfolgenden detaillierten Beschreibung eines Ausführungsbeispiels deutlich, wobei die Erfindung nicht auf dieses Ausführungsbeispiel beschränkt ist.

Eine Lauf - oder Leitschaufel einer Niederdruckturbine eines Flugtriebwerks wird aus einer Nickelbasis - Superlegierung TMS - 238 gegossen und anschließend in einem HIP - Ofen, also einer Heizvorrichtung, die gleichzeitig heißisostatisches Pressen ermöglicht, auf eine Temperatur von 1300°C erwärmt, dann zehn Minuten gehalten, anschließend auf 1310°C erwärmt, um dort wiederum für eine Stunde gehalten zu werden. Danach wird eine Aufheizung auf 1335°C vorgenommen und diese Temperatur für drei Stunden gehalten. Zum Schluss der Lösungsglühbehandlung wird das Halbzeug bei 1345°C für 20 Stunden heißisostatisch gepresst und anschließend mit einer Kühlrate von 400 K/min auf eine Temperatur von unter 400°C, vorzugsweise Raumtemperatur abgekühlt.

Nach dem Entfernen aus dem HIP - Ofen wird das Halbzeug in einer Beschichtungsvorrichtung, beispielsweise einer PVD - Beschichtungskammer durch Verdampfen von Aluminium und Chrom mit einer AlCr - Beschichtung versehen, wobei zur Fertigstellung der Beschichtung eine Diffusionsglühbehandlung, die gleichzeitig auch Ausscheidungsglühbehandlung ist, bei einer Temperatur im Bereich von 1000°C bis 1100°C, beispielsweise 1050°C für 8 bis 24 Stunden, z.B. 20 Stunden durchgeführt wird. Nach dem Abkühlen auf Raumtemperatur ist die Wärmebehandlung mit der Lösungsglühbehandlung und der Ausscheidungsglühbehandlung abgeschlossen und das Bauteil gemäß der Erfindung fertiggestellt. Die entsprechende Lauf- oder Leitschaufel kann dann für mehrere hundert oder tausend Stunden in einer Niederdruckturbine eines Flugtriebwerks eingesetzt werden.

Um sicherzustellen, dass sich nach dem Betrieb der Niederdruckturbine über einen längeren Zeitraum von mehreren 100 Stunden keine spröden TCP - Phasen in der Lauf - bzw. Leitschaufel befinden, wird bei einer Überholung der Niederdruckturbine die entsprechende Leit - bzw. Laufschaufel einer Wiederaufarbeitungswärmebehandlung unterzogen, die bei einer Temperatur im Bereich von 1100°C bis 1200°C, beispielsweise 1150°C für 10 bis 40 Stunden, z.B. 30 Stunden durchgeführt wird. Da sich bei dieser Temperatur der Wiederaufarbeitungswärmebehandlung mögliche TCP - Phasen auflösen, ist nach einer Wärmebehandlung sichergestellt, dass keine spröden Phasen in dem Bauteil mehr enthalten sind, sondern dass das Bauteil wieder sicher verwendet werden kann. Gleichzeitig wird durch die Wärmebehandlung unterhalb der Temperatur für die Auflösung der y' - Ausscheidungsphasen gewährleistet, dass die Festigkeit des Bauteils nicht beeinträchtigt wird.

Obwohl die vorliegende Erfindung anhand der Ausführungsbeispiele detailliert beschrieben worden ist, ist die Erfindung nicht auf diese Ausführungsbeispiele beschränkt, sondern vielmehr sind Abwandlungen in der Weise möglich, dass einzelne Merkmale innerhalb des angegebenen Schutzbereichs der beigefügten Ansprüche verändert werden können. Die Offenbarung schließt sämtliche Kombinationen der vorgestellten Einzelmerkmale mit ein.

## Patentansprüche

1. Verfahren zur Herstellung eines Bauteils, aus einer Nickelbasis - Superlegierung, insbesondere eines Bauteils einer Strömungsmaschine, bei welchem ein Halbzeug des Bauteils einer Lösungsglühbehandlung und einer Ausscheidungsglühbehandlung unterzogen wird, wobei die Lösungsglühbehandlung in einem Temperaturbereich von 1300°C bis 1375°C und die Ausscheidungsglühbehandlung im Temperaturbereich von 900°C bis 1150°C durchgeführt wird,
**dadurch gekennzeichnet, dass**
die Lösungsglühbehandlung und/oder die Ausscheidungsglühbehandlung zusammen mit einer weiteren Bearbeitung des Halbzeugs durchgeführt werden.

2. Verfahren nach Anspruch 1,
**dadurch gekennzeichnet, dass**
die Lösungsglühbehandlung zumindest teilweise gleichzeitig mit heißisostatischem Pressen des Halbzeugs durchgeführt wird.

3. Verfahren nach Anspruch 1 oder 2,
**dadurch gekennzeichnet, dass**
die Ausscheidungsglühbehandlung zumindest teilweise gleichzeitig mit einer Beschichtung des Halbzeugs durchgeführt wird.

4. Verfahren nach Anspruch 3,
**dadurch gekennzeichnet, dass**
zumindest teilweise während der Ausscheidungsglühbehandlung Al - haltige Schichten, insbesondere AlCr - und/oder PtAl - Schichten abgeschieden werden.

5. Verfahren nach einem der Ansprüche 3 bis 4,
**dadurch gekennzeichnet, dass**
die Beschichtung während der Ausscheidungsglühbehandlung durch chemische oder physikalische Dampfphasenabscheidung oder durch Spritzen, insbesondere Heißgasspritzen, oder Niederdruckplasmaspritzen erfolgt.

6. Verfahren nach einem der vorhergehenden Ansprüche,
**dadurch gekennzeichnet, dass**
die Lösungsglühbehandlung bei einer oder mehreren Haltetemperaturen ausgeführt wird, wobei die eine oder letzte Haltetemperatur im Temperaturbereich von 1310°C bis 1375°C, insbesondere im Temperaturbereich von 1340°C bis 1350°C liegt und für eine Dauer von bis zu 15 Stunden, insbesondere bis zu 10 Stunden, vorzugsweise bis zu 5 Stunden gehalten wird.

7. Verfahren nach einem der vorhergehenden Ansprüche,
**dadurch gekennzeichnet, dass**
die Lösungsglühbehandlung mit einer Abkühlung mit einer Kühlrate von 200 K/min oder mehr, vorzugsweise 400 K/min oder mehr beendet wird.

8. Verfahren zur Aufarbeitung eines Bauteils aus einer Nickelbasis - Superlegierung, insbesondere eines Bauteils einer Strömungsmaschine, vorzugsweise hergestellt mit einem Verfahren nach einem der vorhergehenden Ansprüche, nach mehreren hundert Stunden Einsatz bei einer Einsatztemperatur von mehr als 500°C,
**dadurch gekennzeichnet, dass**
eine Wiederaufarbeitungswärmebehandlung in einem Temperaturbereich von 1080°C bis 1280°C durchgeführt wird.

9. Verfahren nach Anspruch 8,
**dadurch gekennzeichnet, dass**
die Wiederaufarbeitungswärmebehandlung bei einer Temperatur 1125°C bis 1275°C, vorzugsweise 1150°C bis 1200°C durchgeführt wird.

10. Verfahren nach einem der Ansprüche 8 bis 9,
**dadurch gekennzeichnet, dass**
die Wiederaufarbeitungswärmebehandlung für eine Zeitdauer von mehr als 10 Stunden, insbesondere mehr als 20 Stunden, vorzugsweise mehr als 25 Stunden durchgeführt wird.

11. Verfahren nach einem der Ansprüche 8 bis 10,
**dadurch gekennzeichnet, dass**
anschließend an die Wiederaufarbeitungswärmebehandlung eine Ausscheidungsglühbehandlung im Temperaturbereich von 900°C bis 1150°C zusammen mit oder ohne einer Beschichtung durchgeführt wird.

12. Verfahren nach Anspruch 11,
**dadurch gekennzeichnet, dass**
zumindest teilweise während der Ausscheidungsglühbehandlung Al - haltige Schichten, insbesondere AlCr - und/oder PtAl - Schichten abgeschieden werden und/oder dass die Beschichtung während der Ausscheidungsglühbehandlung durch chemische oder physikalische Dampfphasenabscheidung oder durch Spritzen, insbesondere Heißgasspritzen, oder Niederdruckplasmaspritzen erfolgt.

13. Verfahren nach einem der Ansprüche 1 bis 7 oder 11 bis 12,
**dadurch gekennzeichnet, dass**
die Ausscheidungsglühbehandlung einstufig durchgeführt wird.

14. Verfahren nach einem der Ansprüche 1 bis 7 oder 11 bis 13,
**dadurch gekennzeichnet, dass**
die Ausscheidungsglühbehandlung für eine Zeitdauer von 5 oder mehr Stunden, insbesondere 10 oder mehr Stunden, vorzugsweise 10 bis 25 Stunden durchgeführt wird, insbesondere im Temperaturbereich von 1000°C bis 1100°C.

15. Verfahren nach einem der Ansprüche 8 bis 14,
**dadurch gekennzeichnet, dass**
vor der Wiederaufarbeitungswärmebehandlung ein Spannungsarmglühen bei einer Temperatur von 850°C bis 1100°C für eine Zeitdauer von 1 bis 5 Stunden, insbesondere 2 bis 4 Stunden durchgeführt wird.

16. Verfahren nach einem der vorhergehenden Ansprüche,
**dadurch gekennzeichnet, dass**
als Nickelbasis - Superlegierung eine Legierung mit der Zusammensetzung verwendet wird, die in Gewichtsprozent
3,7 bis 7,0 %, vorzugsweise 5,0 bis 7,0 %, insbesondere 5,5 bis 6,0 % Al
6 bis 20 %, vorzugsweise 6 bis 8 % oder 10 bis 15,0 %, insbesondere 10,0 bis 12,0 % Co
2,1 bis 7,2 %, vorzugsweise 4,0 bis 6,0 %, insbesondere 4,5 bis 5,5 % Cr
1,0 bis 3,0 %, vorzugsweise 1,1 bis 2,5 %, insbesondere 1,1 bis 2,0 % Mo
5,0 bis 9,2 %, vorzugsweise 5,5 bis 7,0 %, insbesondere 5,7 bis 6,5 % Re
3,0 bis 8,5 %, vorzugsweise 3,1 bis 5,5 %, insbesondere 3,3 bis 5,0 % Ru
4,1 bis 11,9 %, vorzugsweise 5,0 bis 9,0 %, insbesondere 5,5 bis 8,0 % Ta
0 bis 3,3 %, vorzugsweise 0 bis 2,0 %, insbesondere 0 bis 1,7 % Ti
2,1 bis 4,9 %, vorzugsweise 3,0 bis 4,5 %, insbesondere 3,5 bis 4,5 % W
0 bis 0,05 % C
0 bis 0,1 % Si
0 bis 0,05 % Mn
0 bis 0,015 % P
0 bis 0,001 % S
0 bis 0,003 % B
0 bis 0,05 % Cu
0 bis 0,15 % Fe
0 bis 0,5 %, vorzugsweise 0 bis 0,15 % Hf
0 bis 0,015 % Zr
0 bis 0,001 % Y
und Rest Nickel sowie unvermeidbare Verunreinigungen umfasst.
